Europäisches Patentamt

European Patent Office

Office européen des brevets

(11) Publication number: **0 171 226**
**B1**

(12) **EUROPEAN PATENT SPECIFICATION**

(45) Date of publication of patent specification: **19.07.89**

(21) Application number: **85305242.1**

(22) Date of filing: **23.07.85**

(51) Int. Cl.⁴: **H 01 L 21/31**

(54) **A method of making a component for a microelectronic circuit and a semiconductor device and an optical waveguide made by that method.**

(30) Priority: **30.07.84 US 635975**

(43) Date of publication of application:
**12.02.86 Bulletin 86/07**

(45) Publication of the grant of the patent:
**19.07.89 Bulletin 89/29**

(84) Designated Contracting States:
**DE FR GB**

(56) References cited:
**US-A-3 737 341**
**US-A-3 775 262**
**US-A-3 866 310**
**US-A-3 867 148**
**US-A-4 496 419**

(73) Proprietor: **International Business Machines Corporation**
**Old Orchard Road**
**Armonk, N.Y. 10504 (US)**

(72) Inventor: **Hovel, Harold John**
**Diane Court**
**Katonah New York 10536 (US)**
Inventor: **Kuech, Thomas Francis**
**43 Cedar Lane**
**Ossining New York 10562 (US)**

(74) Representative: **Hobbs, Francis John**
**IBM United Kingdom Limited Intellectual Property Department Hursley Park**
**Winchester Hampshire SO21 2JN (GB)**

## Description

This invention relates to a method of making a self-aligned semiconductor device.

Self-aligned semiconductor devices have been prepared by methods that are now considered conventional. Self-alignment generally refers to the positioning of source and drain electrodes next to a gate electrode in a FET device. The self-alignment technique was developed in order to position electrodes relatively close to the gate to avoid high resistance between the electrode and the gate. The resistance between the source electrode and the gate is called the source resistance whereas the resistance between the drain electrode and the gate is called the drain resistance. Although other factors influence source resistance and drain resistance, the distance between the source and drain electrodes and the gate is the most critical factor. When the source resistance and/or the drain resistance is too high, the performance of the FET device may be seriously impaired. The prior art self-alignment technique was achieved by depositing an electrode layer on a substrate and positioning a second layer over the electrode layer, providing an opening in the second layer and etching the first layer through the opening. The etching compound is selected to remove the first layer and not the second layer thereby undercutting the second layer. Since the etching step is followed by the deposition of a material through the opening to form a gate on the substrate and the gate material does not spread out beyond the edges of the opening through which it is deposited, the degree of undercutting (i.e., the degree of removal of the first layer under the second layer) determines the distance of the first layer from the gate or stated otherwise the positioning of the source or drain electrodes with respect to the gate. This procedure is what is known in the art as self-alignment and is relatively more precise than mechanical methods for placing a source and/or drain electrode next to a gate.

Mechanical methods for aligning the electrodes are known and involve for example masking the semiconductor device and depositing the electrodes and/or the gate through an opening in the mask which is difficult because alignment of the openings in the mask is done mechanically and calls for extremely high precision and close tolerances for the constructions of semiconductor devices and especially microcircuits.

Self-aligning methods of the prior art permit separation of elements (e.g., source and drain electrodes relative to a gate electrode in a FET) of fairly close tolerances. Even though this permits construction of microelectronic circuits, it is still desirable to position semiconductor device elements even closer to reduce the resistance between them as for example the source resistance or the drain resistance in a FET.

It is therefore desirable to seek a method that would allow this type of positioning especially positioning of elements within several hundreds of nanometers of one another which is not possible with the self-aligning procedures of the prior art. Self-alignment structures that can be built within these tolerances would provide for the construction of even smaller semiconductor devices than can be made with known methods.

One of the difficulties with the methods presently employed for the construction of self-aligned structures is that an acid etching step is generally used to remove the first layer to provide the opening to the substrate and the acid may remove other elements of the circuit that are to be retained unless etching is properly controlled. Acid etching is difficult to control, however. Additionally, the acids that are commonly employed to remove electrodes may also attack the substrate. The removal of the electrode materials by chemical means such as acid etching according to the prior art process has to be carefully controlled so that the degree of removal of the first layer and consequent undercutting of the second layer is not done to any great extreme not only because of the problems of removing other elements in the microcircuit but also because excess removal of the first layer or electrode material will increase the distance between the electrode and the gate subsequently formed on the device and the source resistance or the drain resistance of the device would be too high due to the excessive distance between the electrodes and the gate.

US—A—3 866 310 discloses a method of making a semiconductor device with a self-aligned gate contact. In that method, a metal layer is deposited on a major surface of a semiconductor member and thereafter overlaid with a resist layer. A window pattern corresponding to a desired gate contact is formed in the resist layer, and the metal layer is undercut by an etchant and removed adjacent the window pattern to expose a portion of the major surface of the semiconductor member and to form overhanging portions of the resist layer adjacent the window pattern. The desired gate contact is then self-aligned on the major surface by deposition through the window pattern in the resist layer.

US—A—3 737 341 discloses a method of depositing a tantalum oxide layer having a predetermined shape on a semi-conductor substrate, comprising the steps of: (a) depositing a film of tantalum on the semiconductor substrate; (b) depositing on the tantalum film a mask of material resistant to thermal treatment, the mask being deposited in a predetermined shape and exposing at least some parts of the tantalum film where the tantalum oxide layer is to be formed; (c) oxidizing the thus-masked substrate by thermal treatment thereby converting the exposed portions of the tantalum layer to tantalum oxide; and (d) chemically etching the assembly and removing the remaining portions of the tantalum film.

According to the invention, there is provided a method of making a self-aligned semiconductor device including forming a first layer of conductive material on a substrate of semiconductor material, forming on the first layer a second layer of material which is different from that of the first layer, and forming an opening in the second layer to expose a portion of the first layer, the method being characterised by contacting the portion of the first layer exposed by the opening with a substance with which it chemically reacts under such conditions that the chemical reaction in the first layer spreads laterally beyond the boundary of the portion of that layer exposed by the opening in the second layer, the conductive material of the first layer being converted by the chemical reaction to a compound having properties different from those of the first and second materials, and subsequently removing the compound and depositing fresh conductive material onto the substrate through the opening in the second layer to form the gate of the semiconductor device.

A self-aligned semiconductor device can be made by a method embodying the invention by depositing a conductor on a semi-conductor substrate and a layer over the conductor. The layer is opened over a region of the substrate on which an additional element is to be placed such as a gate for a field effect transistor (FET). A portion of the conductor is then chemically converted through the opening in the layer to a compound that is removed by a reagent that does not remove the conductor. An element is then applied to the surface of the substrate through the opening. Self alignment is obtained by converting the conductor into a compound to a sufficient distance from the edge of the opening that a controlled amount of undercutting of the layer is provided when the compound is subsequently removed. When the element is applied to the surface of the substrate through the opening, such as the application of a gate for a FET, the edge of the conductor is separated from the element that is deposited through the opening but yet close enough to minimize any electrical resistance between the conductor and the element deposited through the opening. The layer may be of any conducting material which is not chemically converted when the conversion of the underlying conductor into the compound is carried out.

In a specific example a germanium conductor is placed on top of a semiconductor substrate and a gold, molybdenum or palladium layer placed over the germanium. The gold, molybdenum or palladium layer is opened and the germanium underlying the opening is converted to germanium oxide to a predetermined distance beyond the edge of the opening. The germanium oxide is then removed by water or hydrogen chloride or a plasma after which a gate e.g. an electrode, for example of aluminum is deposited through the opening onto the surface of the semiconductor substrate.

By chemically converting a portion of the conductor into a compound that is readily removed by the reagent a high degree of control is possible in placing the conductor in a position next to an element deposited on the semiconductor substrate such as a gate.

Control of the chemical conversion of the conductor is generally more precise and less difficult than the prior art etching methods which were employed to remove the conductor. Additionally, the etching reagents of the prior art tended to remove elements of the device or circuit that are to be retained.

How the invention can be carried out will now be described by way of example, with reference to the accompanying drawings, in which

Figure 1 represents a sectioned side view of a semiconductor substrate having a first and second layer deposited there over;

Figure 2 is a sectioned side view of the structure illustrated in Figure 1 after an opening has been formed in the second layer, and a portion of the first layer chemically converted through the opening;

Figure 3 is a sectioned side view of a self-aligned semiconductor device formed from the structure illustrated in Figure 2; and

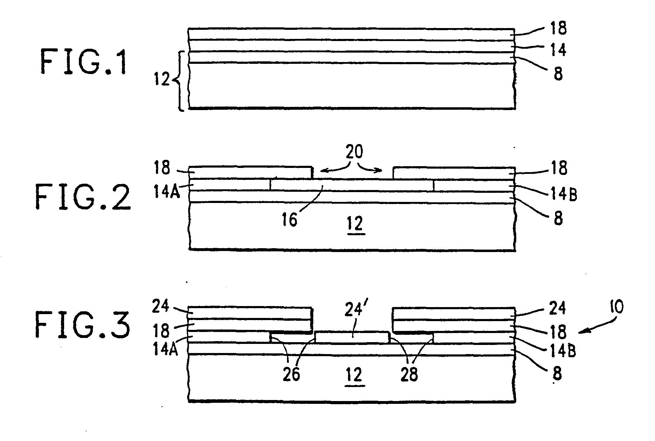

Referring to Figures 1, 2 and 3, a semiconductor device 10 (Figure 3) is formed by a method embodying the present invention. A substrate 12, for example of gallium-arsenide or silicon, is coated with a thin layer of a conductive material 14, e.g., of germanium. A second layer 18 is formed on the layer 14 in a region over and next adjacent to desired location for a circuit component on the substrate 12. The substrate 12 is normally high in electrical resistance and may contain a region which is lower in electrical resistance than the substrate 12. Doped region 8 is produced by ion implantation, diffusion or epitaxial growth techniques. Region 8 is formed before layer 14 is placed on substrate 12. Doped region 8 is typically formed with either silicon, selenium, sulfur, tellurium or tin. The location of the circuit means is defined by producing an opening 20 in layer 18 extending over the region and formed by standard lithographic procedures for semiconductive device purposes. The layer 18 may be a photoresist layer which may be subsequently removed or it may be of a material such as gold, tin, molybdenum, tungsten, or palladium. Once the opening 20 is formed, the structure is placed in an ambient with which the exposed part of the layer 14 reacts and is thereby chemically converted below the opening 20 and in directions extending outwardly from the opening 20 to a compound 16 that is removable from the device by a reagent that will remove the compound 16 at a faster rate then the layer 14 or the layer 18 by which it is meant that the reagent will have substantially minimal to no effect on the layers 14 and 18 as well as the device 10 and substrate 12. In one embodiment, the layer 14 comprises germanium and the ambient in which the device is placed comprises an oxidizing medium such as air or oxygen for the conversion of the layer 14 beneath opening 20 into a portion 16 of germanium oxide. The conductor 14 is then divided into two regions 14A and 14B. Thus when germanium is used as the layer 14 it will be divided into two germanium regions 14A and 14B after conversion of the portion 16 into germanium oxide as described herein above. The conversion of a portion of the layer 14 into a compound 16 is controlled for a distance extending under the layer 18 adjacent the opening 20 in directions substantially parallel to the plane of the device 10 and within a predetermined distance from the edge of opening 20 by controlling the conditions under which the layer 14 is exposed to an ambient through the opening 20. In one example exposure of the layer 14 through the opening 20 to air and/ or other oxygen sources can be effected by the pressure or the partial pressure of the oxidizing ambient, by placement of the device in an autoclave or other pressure device or by mixing the ambient with other nonreactive compounds, such as in the case of an oxidizing gas, e.g., oxygen mixed with nitrogen or a rare gas to control the partial pressure of the oxygen. Compounds consisting of oxides result from oxygen-bearing ambients, while compounds consisting of nitrides result from, say, ammonia-containing ambients with active nitrogen content. The temperature of the ambient can also be adjusted to change the reactivity thereof. Generally, by increasing the temperature and/or pressure of the ambient, the rate of reaction will increase and by reducing the temperature and/or pressure of the ambient the rate of reaction will decrease. The partial pressures may vary from anywhere from about 0.1 atmospheres to slightly less than 1 atmosphere pressure, the pressure range for the ambient, including the partial pressure ranges being anywhere from about 0.1 atmospheres to about 1,000 atomospheres. The ambient may also be ionized by methods well known in the art which increases the reaction rate and allows the reaction to proceed at lower temperatures. The time period over which the layer 14 is exposed to the ambient through the opening 20 is also a factor that will control the extent of the development of the layer 14 into a compound 16 underneath the layer 18. As the time of exposure of layer 14 through opening 20 to the ambient increases, the degree of formation of compound 16 also increases. All of these are parameters that can be adjusted by a person having ordinary skill in the art. In any event, it is critical that the compound 16 is formed to some degree underneath the layer 18 so that subsequent removal of the compound 16 by the reagent will result in some undercutting of the layer 18. Once the compound 16 is formed, to the degree and the extent determined for the production of a self-aligned semi-conductor or other device, the compound 16 is removed. In the case where layer 14 comprises germanium, the compound 16 may consist of germanium oxide which may be removed from the substrate 12 through opening 20 by means of a reagent such as water, hydrogen peroxide, hydrochloric acid or by plasma etching techniques. The plasma employed for removal of the compound 16 may comprise a plasma of a haloflouro lower alkane where the halogen compound in addition to flourine preferably comprises chlorine such as, for example carbon tetraflouride, monochlorotriflouromethane, dichlorodiflouromethane, and trichloromonofluoromethane. After the compound 16 is removed, the substrate 12 may be converted to a semi-conductor device by deposition of a conducting material 24 through opening 20 by a conventional process. Layers 24 and 24' are of the same material and are deposited simultaneously and may comprise, for example tungsten or aluminum, or suitable mixtures such as tungsten — silicon or tungsten-aluminum which is placed on the semi-conductor device 10 by a known method, for example by vapor deposition. Upon heating the device for a time and temperature determinable by a person with ordinary skill in the art, for example for 1 to 5 minutes at 400 to 500° C, ohmic contact between the layer 14 and the region 8 can be formed such as in the case where layer 14A and 14B comprise germanium and the substrate 12 and region 8 comprise gallium arsenide. In this case, a FET is formed in which, after a lead is attached to the element 24' it can serve as a gate whereas the conductor 14A will serve as a source electrode and the conductor 14B will serve as a drain electrode. The distances 26 and 28 between elements 14A and 24 and elements 14B and 24 can be controlled within several hundred nanometers thereby reducing the source resistance between elements 14A and 24' and the drain resistance between elements 14B and 24 to a degree not heretofore readily achieved by known methods. Thus, there has been described herein a self-aligned structure, in which semi-conductor devices can be fabricated and the components of the device can be positioned closer to one another by a method whereby the distances between components are more readily and easily controlled than previously possible.

In another embodiment of the invention, the element 24' may comprise any circuit component for controlling power through the device 10. When element 24' does not comprise a gate, it may comprise another circuit component such as a conductor, a capacitor, a resistor or a seimconductor circuit *per se.*

As another example of the present invention the layer 14 may comprise a titanium or a tantalum layer and the layer 18 may comprise tin, gold, palladium or silver. A portion 16 of the titanium or tantalum will be converted to a compound such as titanium dioxide or tantalum oxide by anodization or oxidation through the opening 20 in the tin, palladium, gold or silver layer after which the oxide may be removed by hydrogen flouride.

Alternatively, the tantalum oxide or the titanium dioxide may be removed by a plasma. The layer 14 may also comprise an aluminum layer which may be converted into a compound comprising aluminum oxide which may be removed by a plasma. Alternatively layer 14 may comprise a silicon layer which may be converted into a compound comprising silicon dioxide which is removed by hydrogen fluoride. Lastly, the layer 14 may comprise either silicon, tantalum, titanium, or hafnium, all of which may be converted to compounds comprising their respective oxides and nitrides and the oxides and nitrides removed by a plasma.

The self-aligned semiconductor devices formed by a method embodying the present invention have application in any of the known electronic circuits employing semiconductor or wave guide means.

## Claims

1. A method of making a self-aligned semiconductor device including forming a first layer (14) of conductive material on a substrate of semiconductor material (12), forming on the first layer a second layer (18) of material which is different from that of the first layer, and forming an opening (20) in the second layer to expose a portion of the first layer, the method being characterised by contacting the portion of the first layer exposed by the opening with a substance with which it chemically reacts under such conditions that the chemical reaction in the first layer spreads laterally beyond the boundary of the portion of that layer exposed by the opening (20) in the second layer, the conductive material of the first layer being converted by the chemical reaction to a compound having properties different from those of the first and second materials, and subsequently removing the compound and depositing fresh conductive material (24) onto the substrate through the opening in the second layer to form the gate of the semiconductor device.

2. A method as claimed in claim 1, in which the compound is removed by contacting it with a solvent.

3. A method as claimed in claim 1, in which the compound is removed by contacting it with a plasma.

4. A method as claimed in any preceding claim, in which the first layer consists of germanium, the second layer consists of gold, molybdenum, palladium, tin or tungsten, and the compound produced by the chemical reaction in the germanium layer is germanium oxide.

5. A method as claimed in claim 4, in which the germanium oxide is removed by contacting it with water or hydrochloric acid.

6. A method as claimed in claim 1, in which the first layer consists of titanium or tantalum, the second layer consists of tin, palladium, gold or silver and the compound produced by the chemical reaction in the titanium or tantalum layer is titanium or tantalum oxide, respectively.

7. A method as claimed in claim 6, in which the titanium or tantulum oxide is removed by contacting it with hydrogen fluoride.

## Patentansprüche

1. Verfahren zur Herstellung einer selbstausgerichteten Halbleitervorrichtung, welches das Ausbilden einer ersten Schicht (14) aus leitfähigem Material auf einem Substrat aus Halbleitermaterial (12), das Ausbilden auf der ersten Schicht einer zweiten Schicht (18) aus einem Material, welches von dem der ersten Schicht verschieden ist, und das Ausbilden einer Öffnung (20) in der zweiten Schicht zur Freilegung eines Abschnitts der ersten Schicht umfaßt, wobei das Verfahren gekennzeichnet ist durch das Kontaktieren des durch die Öffnung freigelegten Abschnitts der ersten Schicht mit einer Substanz, mit welcher sie unter solchen Bedingungen chemisch reagiert, daß die chemische Reaktion in der ersten Schicht sich seitlich über die Grenze des durch die Öffnung (20) in der zweiten Schicht freigelegten Abschnitts jener Schicht hinaus erstreckt, wobei das leitfähige Material der ersten Schicht durch die chemische Reaktion in eine Verbindung mit Eigenschaften umgewandelt wird, die von denjenigen des ersten und zweiten Materials verschieden sind, und ein nachfolgendes Entfernen der Verbindung und Abscheiden von neuem leitfähigen Material (24) auf den Substrat durch die Öffnung in der zweiten Schicht zur Ausbildung des Gate der Halbleitervorrichtung.

2. Verfahren nach Anspruch 1, bei welchem die Verbindung durch Inberührungbringen derselben mit einem Lösungsmittel entfernt wird.

3. Verfahren nach Anspruch 1, bei welchem die Verbindung durch Inberührungbringen derselben mit einem Plasma entfernt wird.

4. Verfahren nach irgendeinem vorstehenden Anspruch, bei welchem die erste Schicht aus Germanium besteht, die zweite Schicht aus Gold, Molybdän, Palladium, Zinn oder Wolfram besteht und die durch die chemische Reaktion in der Germaniumschicht erzeugte Verbindung Germaniumoxid ist.

5. Verfahren nach Anspruch 4, bei welchem das Germaniumoxid durch Inberührungbringen desselben mit Wasser oder Salzsäure entfernt wird.

6. Verfahren nach Anspruch 1, bei welchem die erste Schicht aus Titan oder Tantal besteht, die zweite Schicht aus Zinn, Palladium, Gold oder Silber besteht und die durch die chemische Reaktion in der Titan- oder Tantalschicht erzeugte Verbindung Titan- bzw. Tantaloxid ist.

7. Verfahren nach Anspruch 6, bei welchem das Titan- oder Tantaloxid durch Inberührungbringen desselben mit Fluorwasserstoff entfernt wird.

## Revendications

1. Procédé de réalisation d'un dispositif à semiconducteur auto-aligné comprenant la formation d'une première couche (14) de matériau conducteur sur un substrat de matériau semiconducteur (12), la formation sur la première couche d'une deuxième couche (18) de matériau qui diffère de celui de la première couche et la formation d'une ouverture (20) dans la deuxième couche pour exposer une portion de la première couche, le procédé étant caractérisé par la mise en contact de la portion de la première couche exposée par l'ouverture avec une substance avec laquelle elle réagit chimiquement dans des conditions telles que la réaction chimique ayant lieu dans la première couche s'étale latéralement au-delà de la limite de la portion de cette couche qui est exposée par l'ouverture (20) de la deuxième couche, le matériau conducteur de la première couche étant transformé par la réaction chimique en un composé possédant des propriétés différentes de celles du premier et du deuxième matériaux, puis l'enlèvement du composé et un dépôt de nouveau matériau conducteur (24) sur le substrat à travers l'ouverture de la deuxième couche pour former la grille du dispositif à semiconducteur.

2. Procédé selon la revendication 1, dans lequel le composé est enlevé par mise en contact de celui-ci avec un solvant.

3. Procédé selon la revendication 1, dans lequel le composé est enlevé par mise en contact de celui-ci avec un plasma.

4. Procédé selon l'une quelconque des revendications précédentes, dans lequel la première couche est formée de germanium, la deuxième couche est formée d'or, de molybdène, de palladium, d'étain ou de tungstène, et le composé produit par la réaction chimique dans la couche de germanium est de l'oxyde de germanium.

5. Procédé selon la revendication 4, dans lequel l'oxyde de germanium est enlevé par mise en contact de celui-ci avec de l'eau ou de l'acide chlorhydrique.

6. Procédé selon la revendication 1, dans lequel la première couche est formée de titane ou de tantale, la deuxième couche est formée d'étain, de palladium, d'or ou d'argent, et le composé produit par la réaction chimique dans la couche de titane ou de tantale est de l'oxyde de titane ou de tantale, respectivement.

7. Procédé selon la revendication 6, dans lequel l'oxyde de titane ou de tantale est enlevé par mise en contact de celui-ci avec du fluorure d'hydrogène.

FIG.1

FIG.2

FIG.3